# EUROPÄISCHE PATENTSCHRIFT

(11) **EP 1 518 889 B1**
(45) Veröffentlichungstag und Bekanntmachung des Hinweises auf die Patenterteilung: **11.06.2008**
(21) Anmeldenummer: 04017812.1
(22) Anmeldetag: 28.07.2004
(51) Int. Cl.: C08K 3/00, C08K 9/06, C08L 63/02

(54) **Härtbares Reaktionsharzsystem**
Curable reactive resin system
Système durcissable de résine réactive

(30) Priorität: 29.09.2003 DE 10345139; 30.09.2003 DE 10345312
(43) Veröffentlichungstag der Anmeldung: 30.03.2005
(73) Patentinhaber: ROBERT BOSCH GMBH, 70442 Stuttgart (DE)
(72) Erfinder: Jennrich, Irene, 71364 Winnenden (DE); Leo, Kristian, 71576 Burgstetten (DE); Muzic, Markus, 71711 Murr (DE); Endres, Wolfgang, 73630 Remshalden (DE); Holst, Marco, 70197 Stuttgart (DE)

(56) Entgegenhaltungen:
- EP-A- 0 136 257
- EP-A- 0 426 482
- EP-A- 0 717 073
- WO-A-93/04118
- DE-A- 10 144 871
- DE-B- 1 141 788
- US-A1- 2003 083 401

## Beschreibung

### Stand der Technik

Die Erfindung bezieht sich auf ein härtbares Reaktionsharzsystem und ein Verfahren zur Herstellung derselben sowie dessen Verwendung nach dem Oberbegriff der unabhängigen Ansprüche.

Systeme auf der Basis eines durch eine chemische Reaktion aushärtenden Harzes spielen bei der Herstellung technischer Bauteile und Komponenten eine große Rolle. Werden derartige Reaktionsharzsysteme zu Isolierzwecken eingesetzt, so weisen diese üblicherweise hohe Füllstoffgehalte auf. Hohe Füllstoffgehalte führen zu einer hohen thermischen und mechanischen Beständigkeit der ausgehärteten Reaktionsharzsysteme.

Aus der DE 100 51 051 A1 sind derartige Reaktionsharzsysteme auf der Basis von Epoxidharzen bekannt. Diese weisen einen Füllstoffanteil von bis zu 75 Gew.% auf. Höhere Füllstoffanteile sind mit den dort beschriebenen Systemen nicht realisierbar, da es sonst zu nachteiligen Auswirkungen auf die Viskosität bzw. Verarbeitbarkeit der Vergussmasse kommt.

Der vorliegenden Erfindung liegt die Aufgabe zugrunde, ein härtbares Reaktionsharzsystem bereitzustellen, das eine hohe thermische und mechanische Beständigkeit aufweist und dennoch gut zu verarbeiten ist. Vorteile der Erfindung

Die der Erfindung zugrundeliegende Aufgabe wird erfindungsgemäß durch die Bereitstellung eines Reaktionsharzsystems gelöst, das als Zweikomponentensystem einsetzbar ist und als Füllstoff Nanopartikel enthält. Durch die Verwendung von Nanopartikeln als Füllstoff können zweikomponentige Reaktionsharzsysteme realisiert werden, die einen Füllstoffanteil von bis zu 90 Gew.% aufweisen und dennoch gießfähig sind.

Das Reaktionsharzsystem weist im ausgehärteten Zustand einen geringen linearen Schwund auf und zeichnet sich durch eine hohe Bruchdehnung und einen geringen thermischen Ausdehnungskoeffizienten aus.

Mit den in den Unteransprüchen aufgeführten Maßnahmen sind vorteilhafte Weiterbildungen des erfindungsgemäßen Reaktionsharzsystems möglich.

So weist das Reaktionsharzsystem vorzugsweise als Füllstoff Quarzgut- oder Quarzmehlpartikel auf, die zu einer besonders ausgeprägten thermischen Stabilität sowie zu einem kleinen Ausdehnungskoeffzienten bzw. zu einer geringen Dielektrizitätskonstante führen.

In einer besonders vorteilhaften Ausführung weist das Reaktionsharzsystem als Harzkomponente Bisphenol A, Bisphenol B und/oder Bisphenol F gegebenenfalls in Abmischung mit einem Epoxid auf. Dieses Harzsystem weist einen hohen Vernetzungsgrad und somit eine hohe mechanische Stabilität im ausgehärteten Zustand auf.

### Ausführungsbeispiele

Ein Reaktionsharzsystem gemäß der vorliegenden Erfindung weist drei Grundkomponenten auf, nämlich eine Harzkomponente A, einen Füllstoff B und Polymerpartikel C auf, die in der Harzkomponente A dispergiert sind. Darüber hinaus sind mindestens ein Härter D und übliche Additive wie ein oder mehrere Entschäumer, Sedimentationshemmer und Haftvermittler enthalten.

Allgemein ist zu beachten, dass das Reaktionsharzsystem vor und während der Verarbeitung ein stabiles System bilden muss, um eine Entmischung der Komponenten zu verhindern. So sollten die Füllstoffpartikel B bzw. Polymerpartikel C stabile Dispersionen mit der Harzkomponente A bilden und, sofern mehrere Harzkomponenten A vorliegen, die Harzkomponenten A stabile Lösungen oder Emulsionen untereinander. Diese Stabilität muss sowohl während der Verarbeitung als auch bei der Aushärtung des Reaktionsharzsystems gewährleistet sein.

Als Harzkomponente A kann grundsätzlich eine Vielzahl monomerer, vernetzbarer Verbindungen oder Mischungen derartiger Verbindungen verwendet werden. Besonders vorteilhaft ist die Verwendung von Verbindungen, die mindestens eine Epoxidfunktion aufweisen, gegebenenfalls in Abmischungen mit anderen Verbindungen mit oder ohne Epoxidfunktion. So eignen sich beispielsweise Di-, Tri-, oder Tetraepoxide, wobei die im folgenden aufgeführten, kommerziell erhältlichen Verbindungen exemplarisch aufgeführt sind. Als besonders geeignet haben sich cycloaliphatische, vorzugsweise ringepoxidierte Diepoxide, wie beispielsweise (I) und (VI), erwiesen.

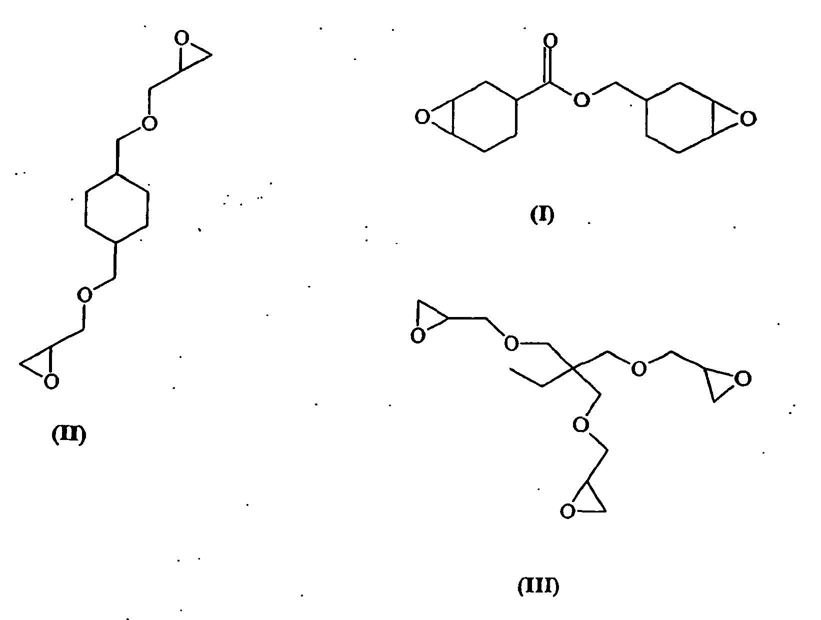

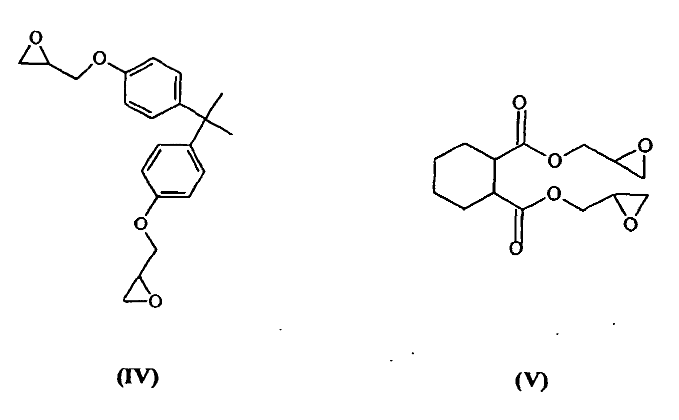

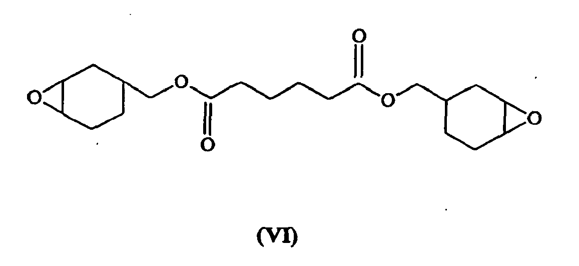

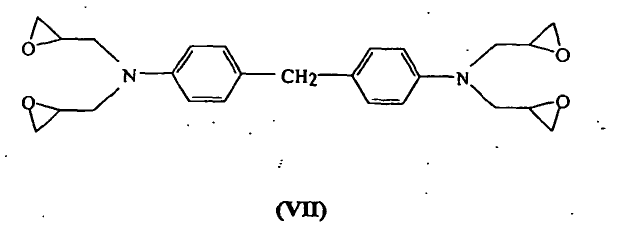

Die Harzkomponente A kann eine oder mehrere der Verbindungen (I) bis (VII) umfassen sowie weitere Harzkomponenten. Alternativ können beispielsweise Harzkömponenten auf der Basis von Bisphenol A, Bisphenol B und/oder Bisphenol F, PUR oder auch Cyanatester alleine oder in Mischungen untereinander bzw. mit geeigneten Epoxidharzkomponenten zum Einsatz kommen.

Weiterhin besteht die Möglichkeit, als Harzkomponente A ein Novolak-Epoxidharz einzusetzen, insbesondere ein Cresol-Novolak-Epoxidharz der folgenden Zusammensetzung:

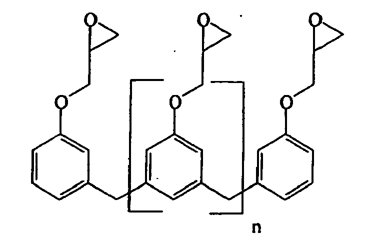

Die Harzkomponente A ist im Reaktionsharzsystem zu 5 bis 95 Gew.%, vorzugsweise zu 10 bis 60 Gew.%, insbesondere zu 12 bis 28 Gew.% enthalten.

Das Reaktionsharzsystem enthält weiterhin einen Füllstoff B, durch dessen geeignete Wahl ein Schwund des Reaktionsharzsystems im ausgehärteten Zustand verringert werden kann und sich thermische Stabilität bzw. Rissfestigkeit des Reaktionsharzsystems im ausgehärteten Zustand erhöht. Der Füllstoff B enthält Nanopartikel, wobei unter Nanopartikel eine Teilchenfraktion zu verstehen ist, deren mittlere Korngrößenverteilung d₅₀ sich im Nanometerbereich bewegt. Als Füllstoffmaterialien eignen sich beispielsweise Aluminiumoxid, Kreide, Siliziumcarbid, Bornitrid, Ruß oder Talkum. Vorzugsweise weist der Füllstoff B Partikel aus Quarzmehl bzw. Quarzgut oder Mischungen derselben auf. In einer besonders bevorzugten Ausführungsform weist der Füllstoff B Partikel zweier unterschiedlicher Korngrößenverteilungen d₅₀ auf. Dabei weist ein erster Teil der Füllstoffpartikel eine Korngrößenverteilung im Nanometerbereich auf und ein zweiter Teil der Füllstoffpartikel eine Korngrößenverteilung d₅₀ vorzugsweise im Mikrometerbereich.

Durch die Verwendung von Nanopartikel ist es möglich, den Gesamtanteil an Füllstoff B innerhalb des Reaktionsharzsystems bis auf 90 Gew.% zu erhöhen, wobei das Reaktionsharzsystem dennoch während des Verarbeitungs- bzw. Aushärtungsvorganges ausreichend fließfähig bleibt. Der gesamte Füllstoffanteil im Reaktionsharzsystem kann somit 2 bis 90 Gew.%, vorzugsweise 50 bis 70 Gew.% betragen, insbesondere 2 bis 25 Gew.%.

Als besonders geeignet hat sich die Verwendung silanisierter Füllstoffpartikel erwiesen, da durch eine Oberflächenmodifizierung der Füllstoffpartikel eine verbesserte Anbindung des Füllstoffs B an die Harzmatrix A des Reaktionsharzsystems gewährleistet ist. Um den Silanisierungsgrad des Füllstoffs B einstellen zu können, wird der Füllstoff entweder vorab mit einem Silanisierungsmittel behandelt und der vorsilanisierte Füllstoff dem Reaktionsharzsystem zugemischt; oder das Silanisierungsmittel wird dem Reaktionsharzsystem zugesetzt und die eigentliche Silanisierungsreaktion läuft im Reaktionsharzsystem ab. Alternativ kann der Füllstoff B auch eine chemisch modifizierte Oberfläche in Form einer Polymerschicht beispielsweise aus PMMA aufweisen (sogenannte Core-Shell-Partikel).

Als dritte Komponente C enthält das Reaktionsharzsystem darüber hinaus in der Harzkomponente A dispergierte Polymerpartikel. Dabei handelt es sich insbesondere um polysiloxanhaltige Polymere, wobei die Komponente C vorzugsweise eine Dispersion eines oder mehrerer Silikone in der Harzkomponente A darstellt. Bevorzugt werden Silikonpartikel in Form von Silikonharz- oder Silikonelastomerpartikel mit einem Teilchendurchmesser von 10 nm bis 100 µm verwendet. Die Silikonpartikel können grundsätzlich eine chemisch modifizierte Oberfläche in Form einer Polymerschicht beispielsweise aus PMMA aufweisen (sogenannte Core-Shell-Partikel); es hat sich jedoch gezeigt, dass unbehandelte bzw. oberflächenfunktionalisierte Silikonpartikel für die der Erfindung zugrundeliegende Aufgabenstellung besser geeignet sind. Alternativ sind Elastomerpartikel aus Acrylnitril-Butadien-Styrol-Copolymerisat (ABS) ebenfalls geeignet.

Das Reaktionsharzsystem enthält bis zu 25 Gew.% an Polymerpartikel C, bevorzugt sind bis zu 10 Gew.%.

Um zu gewährleisten, dass das Reaktionsharzsystem als Zweikomponentensystem verarbeitbar ist, ist weiterhin ein Härter vorgesehen. Hierfür ist beispielsweise Hexahydrophthalsäureanhydrid oder Methylnadicsäureanhydrid (MNSA) geeignet.

Das vorliegende Reaktionsharzsystem kann sowohl als Imprägnierharz, als auch als Vergussmasse eingesetzt werden. Bei Verarbeitung als Imprägnierharz, beispielsweise zur Imprägnierung elektrischer Wicklungen, wird die entsprechende Wicklung in Rotation versetzt und entweder in das flüssige Imprägnierharz eingetaucht oder das flüssige Imprägnierharz wird auf die rotierende Wicklung aufgetropft. Die Aushärtung der imprägnierten Wicklung erfolgt beispielsweise thermisch oder über eine UVunterstützte Vernetzung.

Wird das Reaktionsharzsystem als Vergussmasse eingesetzt, so erfolgt der Verguss zu einem Formteil bei höherer Temperatur. Das Reaktionsharzsystem weist bei entsprechender Erwärmung eine so geringe Viskosität und eine so hohe Kapillarwirkung auf, dass auch ungünstige Geometrien wie Gießspalte mit einem Durchmesser von < 300 µm beim Verguss ausgegossen werden können. Dies ermöglicht gleichzeitig sehr kurze Taktzeiten. Das vergossene Reaktionsharzsystem wird einer Temperatur von 60 bis 110°C für 30 bis 300 Minuten oder von 120°C für 10 bis 100 Minuten ausgesetzt, um ein Gelieren des Reaktionsharzsystems zu erreichen. Danach wird sie für 10 bis 90 Minuten einer Temperatur von 140 bis 220°C zur Aushärtung des Formteils ausgesetzt.

Exemplarisch werden im folgenden Ausführungsbeispiele von Reaktionsharzsystemen bzw. ihrer Zusammensetzungen (in Gew.%) und ihrer resultierenden Eigenschaften im gehärteten Zustand dargestellt. Dabei handelt es sich bei den Ausführungsbeispielen 1 und 2 bzw. 6 und 7 um Referenzproben, die keine Polymerpartikel C und keine Nanoteilchen als Füllstoff B aufweisen.

### I. Die Harzkomponente A entspricht einem cycloaliphatischen Epoxid:

### Zusammensetzungen:

| Ausführungsbeispiel | 1 | 2 | 3 | 4 | 5 |
|---|---|---|---|---|---|
| Harzkomponente A Cycloaliphatisches Epoxid | 16,96 | 45,9 | 13,52 | 12,53 | 18,3 |
| Füllstoff B Quarzgut | 62,52 | - | 62,87 | 57,9 | 49,97 |
| Füllstoff B Quarzgutnanopartikel | - | - | 3.65 | 3,38 | 5,0 |
| Polymerpartikel C Silikonelastomer | - | - | 3,65 | 3,39 | 5,0 |
| Additive | 0.59 | - | 0.34 | 0,318 | 0.08 |
| Härter | 19,93 | 54,1 | 15,97 | 14,78 | 21,65 |

Die obengenannten Zusammensetzungen ergeben folgendes Eigenschaftsprofil:

| Ausführungsbeispiel | 1 | 2 | 3 | 4 | 5 |
|---|---|---|---|---|---|
| Viskosität bei 60 °C [mPa*s] | 2800 | 34 | 5160 | 13000 | 1500 |
| Linearer Schwund [%] | -0,3 | -0,2 | 0,15 | 0,15 | 0,1 |
| Glasübergangstemperatur [°C] | 230 | - | 239 | 226 | 180 |
| Thermischer Ausdehnungskoeffizient [10⁻⁶ * 1/°C] | 32 - 35 | 67 | 23 | 21 | 35 |
| E-Modul Biege-/Zugversuch [N/mm²] | 8990/10200 | 2890/2900 | 9750/10390 | 10360/ 11060 | 6730/6410 |
| Bruch-/Reißspannung [N/mm²] | 104/61 | 124/40 | 108/72 | 98/64 | 107/68 |
| Bruch-/Reißdehnung [%] | 1,0/0,62 | 5,4/1,46 | 1,24/0,91 | 1,05/0,73 | 1,76/1,26 |

### II. Harzkomponente A entspricht einem Bisphenol A - Harz:

### Zusammensetzungen:

| Ausführungsbeispiel | 6 | 7 | 8 |
|---|---|---|---|
| Harzkomponente A Bisphenol A | 51,5 | 25,73 | 20,6 |
| Füllstoff B Quarzgut | - | - | 49,9 |
| Füllstoff B Quarzgutnanopartikel | - | 49,92 | 4,99 |
| Polymerpartikel C Silikonelastomer | - | - | 4,99 |
| Additive | - | 0,16 | 0,18 |
| Härter | 48,5 | 24,19 | 19,34 |

Die obengenannten Zusammensetzungen ergeben folgendes Eigenschaftsprofil:

| Ausführungsbeispiel | 6 | 7 | 8 |
|---|---|---|---|
| Viskosität bei 60 °C [mPa*s] | 51 | - | 1630 |
| Linearer Schwund [%] | 0,7 | - | 0,36 |
| Glasübergangstemperatur [°C] | 149 | - | 133 |
| Thermischer Ausdehnungskoeffizient [10⁻⁶ * 1 /°C] | 66 | - | 33 |
| E-Modul Biege-/Zugversuch [N/mm²] | 2920 | 6930/7050 | 9000/75400 |
| Bruch-/Reißspannung [N/mm²] | 130/55 | 144/89 | 149/73 |
| Bruch-/Reißdehnung [%] | 9,39/2,45 | 2,4711,79 | 2,06/1,65 |

Das Reaktionsharzsystem eignet sich aufgrund seiner thermischen Stabilität im ausgehärteten Zustand vor allem für Bauteile, die zumindest zeitweise Temperaturen bis zu 240°C ausgesetzt sind.

So kann das erfindungsgemäße Reaktionsharzsystem als Vergussmasse beispielsweise zum Verguss von Dioden, Zündspulen oder elektronischen Bauteilen zum Einsatz kommen. Weiterhin können elektrische Wicklungen mit dem Reaktionsharzsystem imprägniert werden.

Weitere vorteilhafte Ausführungsformen der vorliegenden Erfindungen finden sich in den Patentansprüchen.

## Patentansprüche

1. Härtbares Reaktionsharzsystem, insbesondere Vergussmasse Laminier- oder Imprägnierharz, das als Zweikomponentenmasse zu verarbeiten ist und eine Harzkomponente (A), einen mineralischen Füllstoff (B) und in der Harzkomponente (A) dispergierte Polymerpartikel (C) enthält, wobei der Füllstoff (B) Nanopartikel umfasst.

2. Reaktionsharzsystem nach Anspruch 1, **dadurch gekennzeichnet, dass** der Füllstoff Quarzmehl oder Quarzgutmehl enthält

3. Reaktionsharzsystem nach Anspruch 2, **dadurch gekennzeichnet, dass** der Füllstoff oberflächenmodifizieirte Nanopartikel enthält.

4. Reaktionsharzsystem nach einem der vorhergehenden Ansprüche, **dadurch gekennzeichnet, dass** der Füllstoff Partikel zweier unterschiedlicher Korngrößenverteilungen d₅₀ aufweist, wobei eine Korngrößenverteilung im Nanometerbereich liegt.

5. Reaktionsharzsystem nach einem der vorhergehenden Ansprüche, **dadurch gekennzeichnet, dass** die Harzkomponente (A) ein Epoxidharz enthält.

6. Reaktionsharzsystem nach Anspruch 5, **dadurch gekennzeichnet, dass** das Epoxidharz ein Harz auf der Basis eines bis- oder höher funktionellen Epoxids ist.

7. Reaktionsharzsystem nach einem der vorhergehenden Ansprüche, **dadurch gekennzeichnet, dass** die Harzkomponente (A) ein Harz auf der Basis von Bisphenol A, Bisphenol B und/oder Bisphenol F enthält.

8. Reaktionsharzsystem nach einem der vorhergehenden Ansprüche, **dadurch gekennzeichnet, dass** die in der Harzkomponente (A) dispergierten Polymerpartikel (C) Silikonelastomerpartikel sind.

9. Reaktionsharzsystem nach Anspruch 8, **dadurch gekennzeichnet, dass** die Silikonelastomerpartikel einen Teilchendurchmesser von 10 nm bis 100 µm aufweisen.

10. Verfahren zur Herstellung eines härtbaren Reaktionsharzsystems nach mindestens einem der Ansprüche 1 bis 9, **dadurch gekennzeichnet, dass** in einem ersten Schritt Nanopartikel in der Harzkomponente (A) dispergiert werden und in einem zweiten Schritt die in der Harzkomponente (A) dispergierten Nanopartikel mit den in der Harzkomponente (A) dispergierten Polymerpartikeln gemischt und das Reaktionsharzsystem erzeugt wird.

11. Verwendung eines Reaktionsharzsystems nach einem der Ansprüche 1 bis 9 zur Imprägnierung elektrischer Wicklungen.

12. Verwendung eines Reaktionsharzsystems nach einem der Ansprüche 1 bis 9 zum Verguss von Dioden und Zündspulen.

## Claims

1. Curable reactive resin system, especially encapsulating compound, laminating resin or impregnating resin, which is processed as a two-component composition and comprises a resin component (A), a mineral filler (B) and, in dispersion in the resin component (A), polymer particles (C), the filler (B) comprising nanoparticles.

2. Reactive resin system according to Claim 1, **characterized in that** the filler comprises fine quartz powder or fine fused silica powder.

3. Reactive resin system according to Claim 2, **characterized in that** the filler comprises surface-modified nanoparticles.

4. Reactive resin system according to Claim 2 or 3, **characterized in that** the filler contains particles of two different particle-size distributions d₅₀, one particle-size distribution being situated within the nanometre range.

5. Reactive resin system according to one of the preceding claims, **characterized in that** the resin component (A) comprises an epoxy resin.

6. Reactive resin system according to Claim 5, **characterized in that** the epoxy resin is a resin based on an epoxide having a functionality of two or more.

7. Reactive resin system according to one of the preceding claims, **characterized in that** the resin component (A) comprises a resin based on bisphenol A, bisphenol B and/or bisphenol F.

8. Reactive resin system according to one of the preceding claims, **characterized in that** the polymer particles (C) in dispersion in the resin component (A) are silicone elastomer particles.

9. Reactive resin system according to Claim 8, **characterized in that** the silicone elastomer particles have a particle diameter of 10 nm to 100 µm.

10. Process for preparing a curable reactive resin system according to at least one of Claims 1 to 9, **characterized in that** in a first step nanoparticles are dispersed in the resin component (A) and in a second step the nanoparticles in dispersion in the resin component (A) are mixed with the polymer particles in dispersion in the resin component (A) and the reactive resin system is produced.

11. Use of a reactive resin system according to one of Claims 1 to 9 for impregnating electrical windings.

12. Use of a reactive resin system according to one of Claims 1 to 9 for encapsulating diodes and ignition coils.

## Revendications

1. Système de résine réactive durcissable en particulier masse d'encapsulage, résine de laminage ou d'imprégnation, qui doit être traitée comme une masse à deux composants et qui contient un composant résine (A), une charge minérale (B) et des particules polymères (C) dispersées dans le composant résine (A), sachant que la charge (B) renferme des nanoparticules.

2. Système de résine réactive selon la revendication 1,
**caractérisé en ce que**
la charge contient de la poudre de quartz ou de la poudre de silice vitreuse.

3. Système de résine réactive selon la revendication 2,
**caractérisé en ce que**
la charge contient des nanoparticules à surface modifiée.

4. Système de résine réactive selon l'une quelconque des revendications 2 ou 3,
**caractérisé en ce que**
la charge présente des particules ayant deux répartitions granulométriques différentes d50, sachant qu'une répartition granulométrique est de l'ordre du nanomètre.

5. Système de résine réactive selon l'une quelconque des revendications précédentes,
**caractérisé en ce que**
le composant résine (A) contient une résine époxy.

6. Système de résine réactive selon la revendication 5,
**caractérisé en ce que**
la résine époxy est une résine à base d'époxy bifonctionnel ou à fonctionnalité supérieure.

7. Système de résine réactive selon l'une quelconque des revendications précédentes,
**caractérisé en ce que**
le composant résine (A) contient une résine à base de bisphénol A, bisphénol B et/ou bisphénol F.

8. Système de résine réactive selon l'une quelconque des revendications précédentes,
**caractérisé en ce que**
les particules polymères (C) dispersées dans le composant résine (A) sont des particules d'élastomère siliconé.

9. Système de résine réactive selon la revendication 8,
**caractérisé en ce que**
les particules d'élastomère siliconé présentent un diamètre de particule de 10 nm à 100 µm.

10. Procédé de fabrication d'un système de résine réactive durcissable selon au moins l'une quelconque des revendications 1 à 9,
**caractérisé en ce que**
dans une première étape, on disperse les nanoparticules dans le composant résine (A) et, dans une deuxième étape, on mélange les nanoparticules dispersées dans le composant résine (A) aux particules polymères dispersées dans le composant résine (A) et on produit ainsi le système de résine réactive.

11. Utilisation d'un système de résine réactive selon l'une quelconque des revendications 1 à 9, pour imprégner des enroulements électriques.

12. Utilisation d'un système de résine réactive selon l'une quelconque des revendications 1 à 9, pour encapsuler des diodes et des bobines d'allumage.
